(19) Europäisches Patentamt / European Patent Office / Office européen des brevets

(11) **EP 2 185 308 B1**

(12) **EUROPEAN PATENT SPECIFICATION**

(45) Date of publication and mention
of the grant of the patent:
**20.03.2019 Bulletin 2019/12**

(21) Application number: **08771473.9**

(22) Date of filing: **19.06.2008**

(51) Int Cl.:
**B23K 26/067** (2006.01)　　　**H01L 21/268** (2006.01)

(86) International application number:
**PCT/US2008/067493**

(87) International publication number:
**WO 2009/017894 (05.02.2009 Gazette 2009/06)**

(54) **METHOD FOR PARTITIONING AND INCOHERENTLY SUMMING A COHERENT BEAM**

VERFAHREN ZUM UNTERTEILEN UND INKOHÄRENTEN SUMMIEREN EINES KOHÄRENTEN STRAHLS

PROCÉDÉ DE SÉPARATION ET D'ADDITION DE MANIÈRE INCOHÉRENTE D'UN FAISCEAU COHÉRENT

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **31.07.2007　US 831830**

(43) Date of publication of application:
**19.05.2010　Bulletin 2010/20**

(73) Proprietor: **Applied Materials, Inc.**
**Santa Clara, CA 95054 (US)**

(72) Inventors:
 • **JENNINGS, Dean**
　**Beverly, Massachusetts 01915 (US)**
 • **THOMAS, Timothy N.**
　**Portland, Oregon 97229 (US)**
 • **MOFFATT, Stephen**
　**Channel Islands JE3 1LL (GB)**
 • **LI, Jiping**
　**Palo Alto, California 94306 (US)**
 • **ADAMS, Bruce E.**
　**Portland, Oregon 97239 (US)**
 • **HOWELLS, Samuel C.**
　**Portland, Oregon 97206 (US)**

(74) Representative: **Zimmermann & Partner**
**Patentanwälte mbB**
**Postfach 330 920**
**80069 München (DE)**

(56) References cited:
**US-A- 5 148 318**　　　**US-A- 5 875 030**
**US-A- 5 883 746**　　　**US-A1- 2004 120 050**
**US-A1- 2004 120 050**

## Description

BACKGROUND OF THE INVENTION

Field of the Invention

Embodiments of the present invention generally relate to coherent pulsed light sources such as lasers and, more particularly, to pulse stretching and temporally and spatially decorrelating coherent light in an effort to provide intense and uniform illumination.

Description of the Related Art

The integrated circuit (IC) market is continually demanding greater memory capacity, faster switching speeds, and smaller feature sizes. One of the major steps the industry has taken to address these demands is to change from batch processing silicon wafers in large furnaces to single wafer processing in a small chamber.

During such single wafer processing the wafer is typically heated to high temperatures so that various chemical and physical reactions can take place in multiple IC devices defined in the wafer. Of particular interest, favorable electrical performance of the IC devices requires implanted regions to be annealed. Annealing recreates a more crystalline structure from regions of the wafer that were previously made amorphous, and activates dopants by incorporating their atoms into the crystalline lattice of the substrate, or wafer. Thermal processes, such as annealing, require providing a relatively large amount of thermal energy to the wafer in a short amount of time, and thereafter rapidly cooling the wafer to terminate the thermal process. Examples of thermal processes currently in use include Rapid Thermal Processing (RTP) and impulse (spike) annealing.

A drawback of RTP processes is that they heat the entire wafer even though the IC devices typically reside only in the top few microns of the silicon wafer. This limits how fast one can heat up and cool down the wafer. Moreover, once the entire wafer is at an elevated temperature, heat can only dissipate into the surrounding space or structures. As a result, today's state of the art RTP systems struggle to achieve a 400°C/s ramp-up rate and a 150°C/s ramp-down rate. While RTP and spike annealing processes are widely used, current technology is not ideal, and tends to ramp the wafer temperature during thermal processing too slowly and thus expose the wafer to elevated temperatures for too long a period of time. These thermal budget type problems become more severe with increasing wafer sizes, increasing switching speeds, and/or decreasing feature sizes.

To resolve some of the problems raised in conventional RTP type processes various scanning laser anneal techniques have been used to anneal the surface(s) of the substrate. In general, these techniques deliver a constant energy flux to a small region on the surface of the substrate while the substrate is translated, or scanned, relative to the energy delivered to the small region. Due to the stringent uniformity requirements and the complexity of minimizing the overlap of scanned regions across the substrate surface these types of processes are not effective for thermal processing contact level devices formed on the surface of the substrate.

Pulsed laser annealing techniques have been used to anneal finite regions on the surface of the substrate to provide well defined annealed and/or remelted regions on the surface of the substrate. In general, during a pulsed laser anneal process various regions on the surface of the substrate are exposed to a desired amount of energy delivered from the laser to cause the preferential heating of desired regions of the substrate. Pulsed laser annealing techniques have an advantage over conventional processes that sweep the laser energy across the surface of the substrate, since the need to tightly control the overlap between adjacently scanned regions to assure uniform annealing across the desired regions of the substrate is not an issue, since the overlap of the exposed regions of the substrate is typically limited to the unused space between die, or "kerf" lines.

However, light waves produced by a laser often have high temporal and spatial coherence. Coherence is the property of waves that enables them to exhibit interference where at least two waves are combined to add constructively or subtract destructively depending on the relative phase between the waves. Temporal coherence characterizes how well a wave can interfere with itself at a different time and may be defined as the measure of the average correlation between the values of a wave at every pair of times separated by a given delay. Thus, a wave containing only a single frequency (a perfect sine wave or monochromatic light) is perfectly correlated at all times, while a wave whose phase drifts quickly will have a short coherence time. The most monochromatic sources are usually lasers, and higher quality lasers tend to have long correlation lengths (up to hundreds of meters). White light, which comprises a broad range of frequencies, is a wave which varies quickly in both amplitude and phase leading to a short coherence time (approximately 10 periods); thus, white light is usually considered as incoherent. Spatial coherence describes the ability for two points in the extent of a wave to interfere when averaged over time. More precisely, spatial coherence may be defined as the cross-correlation between two points in a wave for all times.

The coherence of laser beams manifests itself as speckle patterns and diffraction fringes, which suggest deviation from the desired uniform illumination in pulsed laser annealing and other applications. A speckle pattern is a random intensity pattern produced by the mutual interference of coherent waves that are subject to phase differences and/or intensity fluctuations. Because the surfaces of most materials are extremely rough on the scale of an optical wavelength (~500 nm), coherent light from a laser, for example, reflected from such a surface results in many coherent wavelets, each arising from a different microscopic element of the surface. At any moderately distant point from the surface, the distances traveled by these various wavelets may differ by several wavelengths, and the interference of these wavelets of various phases results in the granular pattern of intensity called speckle. In other words, each point in the speckle pattern is a superposition of each point of the rough surface contributing with a random phase due to path length differences. Diffraction fringes are formed when light from a point source, such as a laser, passes by an opaque object of any shape.

Spatial coherence of light sources has been addressed by the use of random phase plates, also known as diffusers. Intended to scatter the light, optical diffusers increase the frequency of modulation due to interference, but they do not eliminate the interference. However, for pulsed laser annealing techniques and other applications, it is not sufficient to simply increase the frequency of modulation with a diffuser; the depth of modulation from coherence effects should be reduced, as well.

According to US 2004/120050 A1. a laser annealing apparatus includes a beam splitter composed of first and second beam splitters disposed in parallel to each other to split one laser beam into four laser beams not interfering with each other, and a reflecting mirror. Upon the second beam splitter, there are incident a transmitted beam from the first beam splitter and a laser beam outgoing from the first beam splitter and then reflected by the reflecting mirror. The second beam splitter provides two transmitted beams to outside, and the reflecting mirror reflects the reflected beam from the second beam splitter for traveling to outside. The distance between the two beam splitters, and the distance between the first beam splitter and reflecting mirror, is larger than L/(2cosθ)) (where θ is an incident angle and L is a coherence length).

US 5 148 318 A discloses an optical pulse waveform shaper capable of providing an optical pulse waveform of a desired intensity distribution with little loss. The optical pulse beam split by a beam splitter is directed into the beam splitter with a phase difference to combine with the transmitted optical pulse beam. The phase difference is controllable. The optical pulse waveform shaper is applicable between a laser oscillator with different exciting conditions and an amplifier.

Accordingly, what are needed are techniques and apparatus for temporally and spatially decorrelating light from a coherent light source to provide incoherent light.

SUMMARY OF THE INVENTION

Embodiments of the present invention generally relate to decorrelating coherent light from a light source, such as a pulsed laser, in both time and space in an effort to provide intense and uniform illumination.

One embodiment of the present invention is a method for decorrelating a coherent light beam. The method generally includes providing a plurality of beam splitters aligned along an optical axis, wherein each of the beam splitters is configured to divide an incident light beam into an on-axis component beam traveling substantially along the optical axis and an off-axis component beam traveling substantially perpendicular to the optical axis; transmitting the coherent light beam to a first beam splitter in the plurality; combining on-axis and off-axis component beams received from a last beam splitter in the plurality in a beam combiner aligned with the optical axis of the beam splitters and to form incoherent light; and optically steering the off-axis component beams to a subsequent beam splitter in the plurality of beam splitters or to the beam combiner.

Another embodiment of the present invention is a method for decorrelating a coherent light beam. The method generally includes providing N beam splitters, dividing the coherent light beam into $2^N$ component beams using the N beam splitters, and combining the $2^N$ component beams by a beam combiner aligned with the optical axis of the beam splitters to form an incoherent light beam.

Yet another embodiment of the present invention provides an apparatus for decorrelating coherent light. The apparatus generally includes a plurality of beam splitters aligned along an optical axis, wherein each of the beam splitters is configured to divide an incident light beam into an on-axis component beam traveling substantially along the optical axis and an off-axis component beam traveling substantially perpendicular to the optical axis, a first beam splitter in the plurality being configured to receive the coherent light; a beam combiner aligned with the optical axis of the beam splitters and configured to combine on-axis and off-axis component beams received from a last beam splitter in the plurality to form incoherent light; and a plurality of optical steering devices configured to direct off-axis component beams to a subsequent beam splitter in the plurality of beam splitters or to the beam combiner.

An embodiment useful for understanding the present invention provides an apparatus for decorrelating a coherent light beam. The apparatus generally includes N beam splitters configured to divide the coherent light beam into $2^N$ component light beams and a beam combiner adapted to combine the $2^N$ component light beams into a temporally and spatially incoherent light beam.

Yet another embodiment useful for understanding the present invention provides a laser processing system. The laser processing system generally includes a laser source for providing coherent light, a decorrelator coupled to the laser source, and a target coupled to the decorrelator, wherein the target receives incoherent light. The decorrelator generally includes a plurality of beam splitters aligned along an optical axis, wherein each of the beam splitters is configured to divide an incident light beam into an on-axis component beam traveling substantially along the optical axis and an off-axis component beam traveling substantially perpendicular to the optical axis, a first beam splitter in the plurality being configured to receive the coherent light; a beam combiner configured to combine on-axis and off-axis component beams received from a last beam splitter in the plurality to form incoherent light; and a plurality of optical steering devices configured to direct off-axis component beams to a subsequent beam splitter in the plurality of beam splitters or to the beam combiner.

Yet another embodiment useful for understanding the present invention is a method. The method generally includes positioning a plurality of beam splitters along an optical axis and transmitting a coherent pulse of energy through the plurality of beam splitters to form a composite pulse of energy. The composite pulse of energy generally has an amount of energy transmitted through the plurality of beam splitters and an amount of energy reflected at least once in the plurality of beam splitters such that the composite pulse of energy is temporally and spatially incoherent.

BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

FIG. 1A is a block diagram of a laser processing system incorporating a decorrelator to produce spatially and temporally incoherent light in accordance with an embodiment of the present invention.

FIG. 1B illustrates the function of a pulse stretcher in accordance with an embodiment of the present invention.

FIG. 2 illustrates an apparatus for decorrelating incident coherent light using 5 beam splitters (3 cube beam splitters and 2 plate beam splitters) facing the same direction, a plurality of optical steering devices (including 9 retroreflectors), and a beam combiner in accordance with an embodiment of the present invention.

FIG. 2A is a chart of the number of off-axis excursions and corresponding delays experienced by each component beam output by a given beam splitter and its associated optical steering device(s) in FIG. 2 in accordance with an embodiment of the present invention.

FIG. 3 is a flow diagram for decorrelating incident coherent light in accordance with an embodiment of the present invention.

FIG. 4 illustrates producing 8 component light beams from 2 incident light beams using two beam splitters in accordance with an embodiment of the present invention.

FIG. 5 illustrates an apparatus for decorrelating incident coherent light using 5 beam splitters (3 cube beam splitters and 2 plate beam splitters) facing alternating directions, a plurality of optical steering devices (including 5 retroreflectors), and a beam combiner in accordance with an embodiment of the present invention.

FIG. 6 illustrates an apparatus for decorrelating incident coherent light using 10 beam splitters (3 cube beam splitters and 7 plate beam splitters) facing alternating directions, a plurality of optical steering devices (including 9 retroreflectors), and a beam combiner in accordance with an embodiment of the present invention.

DETAILED DESCRIPTION

Embodiments of the present invention decorrelate temporally and spatially coherent light from a light source in an effort to provide intense and uniform illumination. For some embodiments employing a pulsed light source, the output pulse may be stretched relative to the input pulse width. The methods and apparatus described herein may be incorporated into any application where intense, uniform illumination is desired, such as pulsed laser annealing, welding, ablating, and wafer stepper illuminating.

AN EXEMPLARY LASER PROCESSING SYSTEM

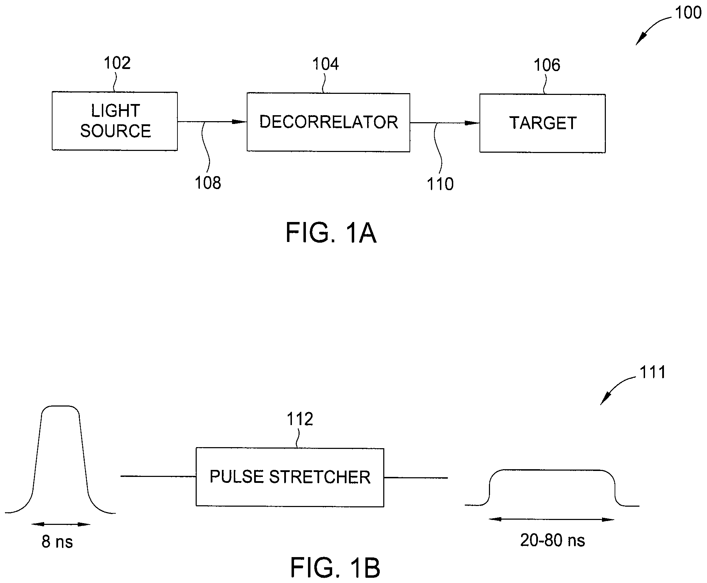

For example, in an exemplary laser processing system 100 of FIG. 1, a light source 102, such as a pulsed laser, may be provided for sourcing temporally and spatially coherent light. For some embodiments, the light source 102 may represent a plurality of light sources that have been combined to form a single light beam. For instance, two or more light sources may be adapted to deliver synchronized pulses of energy to subsequent components in the optical system. The output of each of the light sources may be combined using multiple beam splitters, mirrors, optical prisms, and/or other suitable optical components well-known in the art. The amplitude and duration of each of the pulses delivered from each of the two or more light sources may be adjusted in an effort to provide a composite energy profile with desirable pulse characteristics. Because techniques for combining light from a plurality of sources are known to those skilled in the art and are beyond the scope of the present invention, such techniques will not be described herein.

For a pulsed laser, energy pulse characteristics of the light source 102 may typically include, but are not limited to, the total amount of energy, the peak energy level, the energy flux, the energy density, the pulse profile, the period, and/or the duration of the pulse. In a pulsed laser annealing application if the energy pulse characteristics are not optimized, damage to a substrate may be created by the stress induced from the rapid heating of the melted regions on the surface of the substrate. The rapid heating may generate acoustic shock waves in the substrate that can cause cracks, induce stress, and otherwise damage various regions of the substrate. It should be noted that energy pulse durations that are too long are also undesirable since this may cause dopants in the anneal regions to undesirably diffuse into adjacent regions of the substrate. Therefore, energy pulse characteristics of the light source 102 for a given application should be controlled.

For laser annealing applications, as an example, the dose of energy delivered from the light source 102 may be between about 1 and about 10 Joules over an 8 to 10 nanosecond (ns) pulse duration, which is equivalent to delivering an average total power of between about 100 MW to about 1250 MW in each pulse to the anneal region. It should be noted that the instantaneous power delivered at any time during each pulse may be much higher or lower than the average due to variations in the profile of the energy pulse.

Since the effectiveness of the laser annealing process, for example, is dependent on the transmission, absorption, and reflection of the delivered energy by the material to be annealed, the wavelength ($\lambda$) or wavelengths of the energy delivered by the light source 102 may be tuned so that a desired amount of energy is delivered to a desired depth within the substrate. It should be noted that the amount of energy delivered by each photon of light also varies as a function of wavelength ($E = hc/\lambda$), and thus, the shorter the wavelength, the greater the energy delivered by each photon of light. However, in some cases the substrate material, such as silicon, has an absorption edge that varies with thickness and wavelength, which limit the wavelengths that are absorbed by the substrate material. Therefore, depending on the thickness and type of material from which the substrate is made, the wavelength(s) of the emitted radiation may be varied to achieve the desired energy transfer to the substrate to minimize damage and promote uniform heating of the exposed region of the substrate. In one embodiment, the light source 102 is adapted to deliver energy at a wavelength less than about 1064 nm to a primarily silicon-containing substrate. In one embodiment, the laser annealing process is performed on a silicon-containing substrate using radiation that is delivered at wavelengths that are less than about 800 nm. In another embodiment, the wavelength of delivered from the light source 102 is about 532 nm to the primarily silicon-containing substrate. In yet another embodiment, the wavelength of the optical energy delivered from the energy source is about 216 nm or about 193 nm to the primarily silicon-containing substrate. For some embodiments, an Nd:YAG (neodymium-doped yttrium aluminum garnet) laser adapted to deliver energy at a wavelength between about 266 nm and about 1064 nm may be used.

The light source 102 may be optically coupled to a decorrelator 104 for producing incoherent light in an effort to uniformly illuminate a target 106, such as a substrate undergoing semiconductor processing (*e.g.*, pulsed laser annealing) or two components being welded together. Optical coupling between the light source 102 and the decorrelator 104 and between the decorrelator 104 and the target 106 may occur via simple linear alignment of the devices, optical steering devices (e.g., mirrors, lenses, and beam splitters), optical fibers, and/or other optical waveguides depending on the application. Although not shown in the system 100 of FIG. 1, optional optical conditioning devices (*e.g.*, optical filters) may also be coupled between the light source 102 and the decorrelator 104 and between the decorrelator 104 and the target 106 in an effort to process the coherent light beam 108 before decorrelation or the incoherent light beam 110 before delivery to the target 106. For example, a beam homogenizer may be interposed between the decorrelator 104 and the target 106 in an effort to create a light beam with uniform power across the whole beam profile (*e.g.*, uniform in time and area).

The decorrelator 104 may eliminate certain undesirable effects from the coherent light, such as speckle or fringe formation. For some embodiments, the decorrelator 104 may also function as a pulse stretcher 112 as illustrated in FIG. 1B. The pulse stretcher 112 may receive an input pulse 114 of energy, such as a laser pulse from a pulsed laser source, and produce an output pulse 116 of energy with longer duration. For example, an input pulse 114 with a pulse width of 8 ns may be transmitted to the pulse stretcher 112, which may, in turn, output a pulse 116 having a pulse width of about 20 to 80 ns. The amplitude of the output pulse 116 may be proportional to (and typically lower than) the amplitude of the input pulse 114.

## AN EXEMPLARY COHERENT LIGHT DECORRELATOR

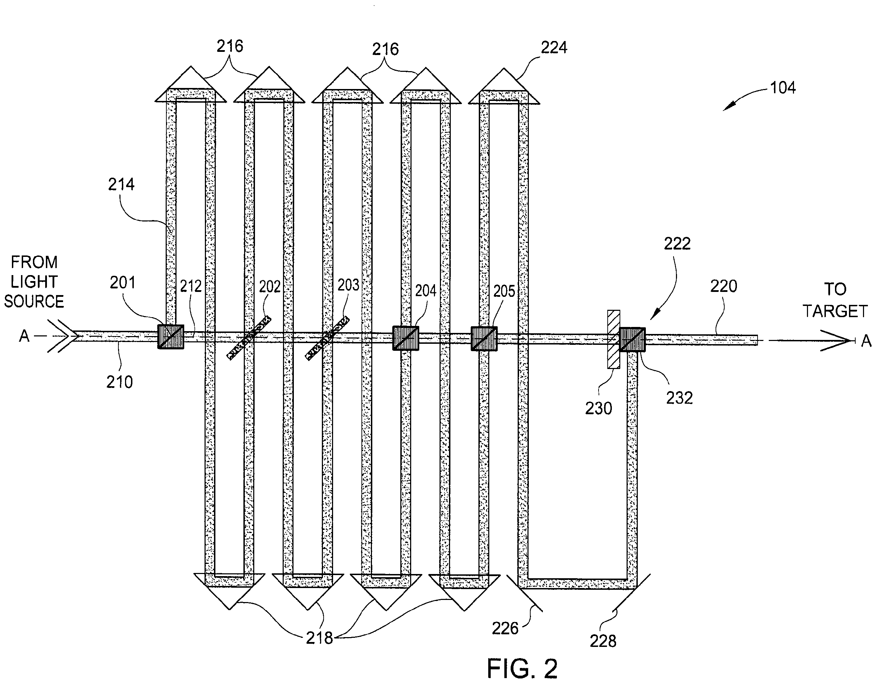

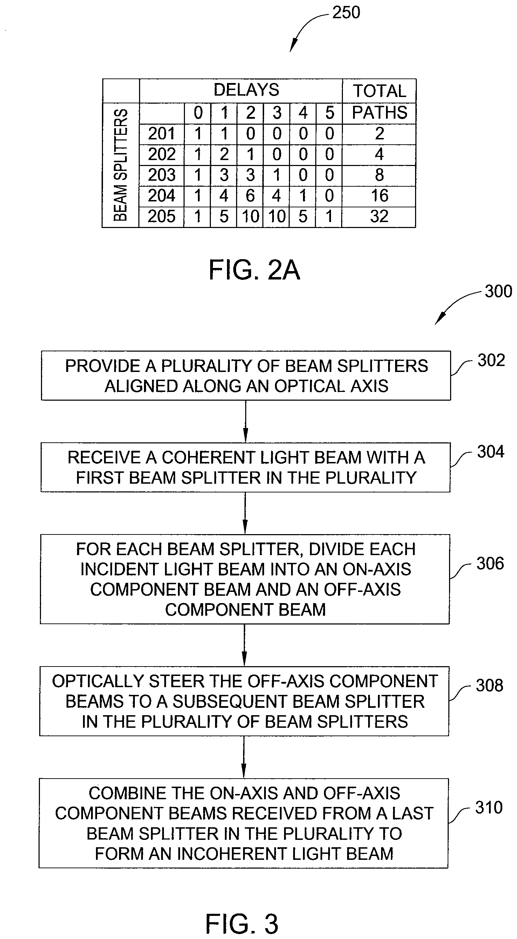

One exemplary embodiment of a decorrelator 104 is illustrated in FIG. 2, which will be described in conjunction with the flow diagram 300 of FIG. 3. The decorrelator 104 may be composed of a plurality of beam splitters 201-205, which may be substantially aligned along an optical axis A-A for the decorrelator 104 in step 302. The spacing between the beam splitters 201-205 may not be critical for decorrelating the coherent light from the light source 102. That being said, a typical spacing between the beam splitters is about 5 to 10 cm.

A beam splitter, as used herein, may be generally defined as an optical device that splits a beam of light into two component light beams, a transmitted beam and a reflected beam. Beam splitters may be characterized according to the ratio of reflected intensity to transmitted intensity (R:T). Thus, a beam splitter with a 30:70 ratio reflects about 30% of the energy in the incident light beam and transmits approximately 70% of the energy. There are two main types of beam splitters: plate beam splitters and cube beam splitters.

Plate beam splitters, or plate dividers, consist of a thin plate of optical glass, quartz, or single-axis crystals (*e.g.*, CaF$_2$) with a different type of coating deposited on each side. The first side may be coated with a metallic coating or a dielectric film having partial reflection properties in the optical spectrum. Metallic coatings tend to have considerable absorption, thereby lowering the intensity of reflected and transmitted component light beams after splitting. Dielectric coatings usually are characterized by having no absorption qualities, so such coatings may be used for beam splitters in applications with high-power laser systems, such as a pulsed laser annealing system. The second side may have an anti-reflection coating optimized for 45° (the angle most frequently used in applications employing plate beam splitters) with minimum reflectivity in an effort to avoid unwanted additional reflections. This anti-reflection coating may have a reflectivity of only 0.5% at an angle of incidence of 45°.

A cube beam splitter may be formed from two matched right-angle triangular glass prisms that are glued together at their hypotenuses using optical cement, such as Canada balsam, a transparent resin obtained from the balsam fir. The thickness of the optical cement layer may be designed such that a desired portion of the light incident through one face of the cube is reflected and the remaining portion is transmitted for a given wavelength. Prior to cementing, a partial reflection film (*e.g.*, a metallic or dielectric coating) is deposited onto the hypotenuses of the right-angle prisms. The other four faces of both prisms may be antireflection-coated in an effort to minimize ghost images.

Plate beam splitters have a number of advantages over cube beam splitters. First of all, plate beam splitters are devoid of optical cements, which may absorb light energy. Thus, plate beam splitters can withstand significantly higher levels of laser power without damage, an important consideration when using moderate- or high-power lasers. As described above, the light source used in pulsed laser annealing applications may deliver an average total power between about 100 MW and 1250 MW. Plate beam splitters may also be significantly smaller and lighter than cube beam splitters. However, plate beam splitters introduce a shift, or a deviation, into the light beam due to their thickness.

Conversely, cube beam splitters are rugged, easy to mount, and ideal for beam superposition applications. Cube beam splitters deform much less when subjected to mechanical stress when compared to plate beam splitters and do not introduce a shift in the light beam. Most of the unwanted reflections from a cube beam splitter are in the retrodirection (*i.e.*, the opposite direction from the incident direction and along the same optical axis) and thus, do not contribute to ghost images. Furthermore, because the metallic or dielectric coating is sealed within the body of the cube, the coating is very resistant to degradation with time.

That being said, the plurality of beam splitters 201-205 may comprise plate beam splitters, cube beam splitters, or a combination of plate and beam splitters as shown. In the decorrelator 104 of FIG. 2, cube beam splitters 201, 204, 205 and plate beam splitters 202, 203 are employed. For some embodiments, the beam splitters 201-205 may be non-polarizing beam splitters where the polarizations of the transmitted and reflected component beams are not influenced by the beam splitter, so the polarization of the incident radiation is maintained. A combination of splitting ratios may be selected for the beam splitters 201-205 in the decorrelator 104. For example, some beam splitters 201-204 may possess a 50:50 splitting ratio, while other beam splitters 205 may have a 30:70 splitting ratio.

The first beam splitter 201 may receive an incident light beam 210 from the light source 102 in step 304. As described above, the incident light beam 210 may be a series of laser pulses, each pulse having a pulse width of 8 ns, for example. In step 306, the incident light beam 210 may be divided into a transmitted component beam 212 and a reflected component beam 214 by the first beam splitter 201. With the plate beam splitter or the hypotenuse of a cube beam splitter angled at around 45° with respect to the incident light beam 210, the transmitted component beam 212 may remain substantially on the optical axis A-A (*i.e.*, an on-axis component beam), and the reflected component beam 214 may be diverted substantially perpendicular to the optical axis A-A (*i.e.*, an off-axis component beam) as illustrated. For some embodiments, plate or cube beam splitters characterized by or positioned to have other angles besides 45° with respect to the optical axis A-A may be utilized, thereby creating off-axis component beams at an angle other than 90° with respect to the optical axis.

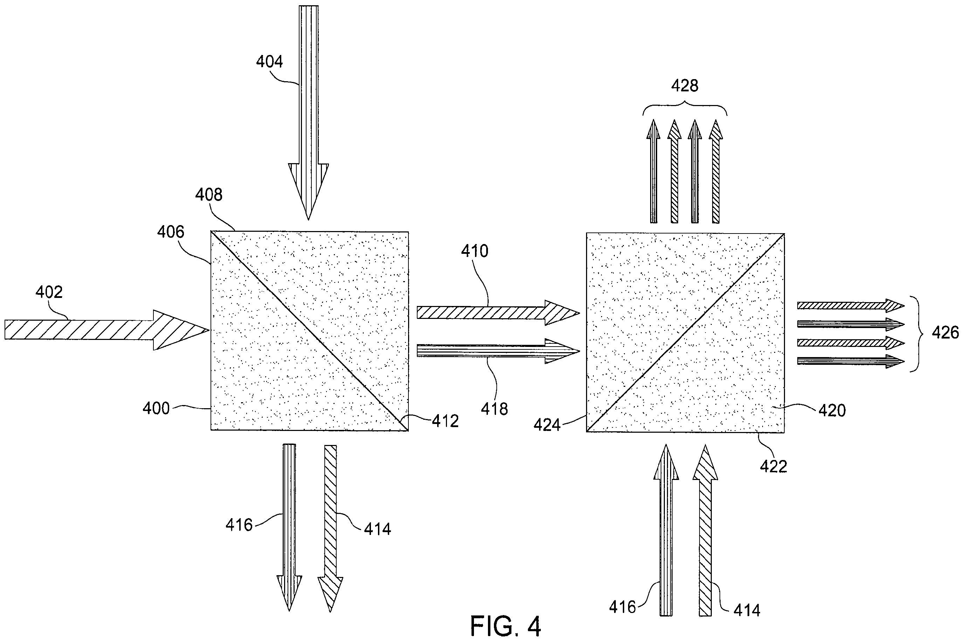

In a similar fashion, each beam splitter 201-205 may receive component light beams from two different directions and transmit component light beams in two different directions. The number of component light beams may be doubled by each beam splitter 201-205 as illustrated in FIG. 4. In FIG. 4, a cube beam splitter 400, such as beam splitter 202 from FIG. 2, may receive two incident component light beams 402, 404 on two different faces 406, 408, or ports, of the cube. Incident component light beam 402 may be substantially on the optical axis A-A for the decorrelator 104, and incident component light beam 404 may be substantially perpendicular to the optical axis A-A. A portion of the incident component light beam 402 may be transmitted through the cube beam splitter 400 to form component light beam 410, while the remaining portion may be reflected by the hypotenuse 412 of the cube beam splitter 400 to generate component light beam 414, traveling substantially perpendicular to the optical axis A-A. Similarly, a portion of the incident component light beam 404 may be transmitted through the beam splitter 400 to create component light beam 416, and the remaining portion may be reflected by the opposite side of the hypotenuse 412 to form component light beam 418. In this manner, a beam splitter 400 may be utilized to generate four component light beams 410, 414, 416, 418 from two incident component light beams 402, 404.

In a similar manner, if the two off-axis component light beams 414, 416 from the first beam splitter 400 are redirected to a second beam splitter 420 such that the two off-axis component light beams 414, 416 reach one face 422 of the second beam splitter 420 different from the face 424 upon which the on-axis component beams 410, 418 are incident, the second beam splitter may generate four on-axis component light beams 426 and four off-axis component light beams 428. In essence, four component light beams may be produced from two incident component light beams using only a single beam splitter, and the number of component light beams produced may be doubled to eight by using a second beam splitter.

This line of reasoning may be extended to N beam splitters. For N beam splitters where the on-axis component light beams from one beam splitter are incident on the next beam splitter and the off-axis component light beams from the same one beam splitter are redirected to be incident on the same next beam splitter, the number of component beams produced may be expressed as $2^N$. Thus, for the plurality of beam splitters 201-205 illustrated in FIG. 2, the number of component light beams produced in the last beam splitter 205 would be 32 (= $2^5$).

The off-axis component light beams, such as reflected component beam 214 and off-axis component light beams 414, 416, 428 in FIG. 4, from one beam splitter may be optically steered and redirected to a subsequent beam splitter in step 308 by any optical steering device suitable for reflecting or redirecting light without significant optical loss, such as a mirror, a retroreflector, or an optical fiber. A retroreflector as used herein may be generally defined as a device that reflects light along a path parallel to an incident light beam regardless of the angle of incidence. For example, the reflected component beam 214 from the first beam splitter 201 may be redirected by a primary retroreflector 216 to a secondary retroreflector 218. The secondary retroreflector 218 may redirect the reflected component beam 214 to the second beam splitter 202 for additional optical splitting.

For some embodiments using retroreflectors 216, 218 as the optical steering devices, the size of the retroreflectors may dictate the spacing between adjacent beam splitters, or a desired spacing between adjacent beam splitters may lead to the selection of retroreflectors with a corresponding size. Using other suitable optical steering devices, such as an optical fiber or combination of mirrors, may remove such restrictions on the spacing between adjacent beam splitters, allowing more freedom when designing the placement of the beam splitters and the decorrelator size.

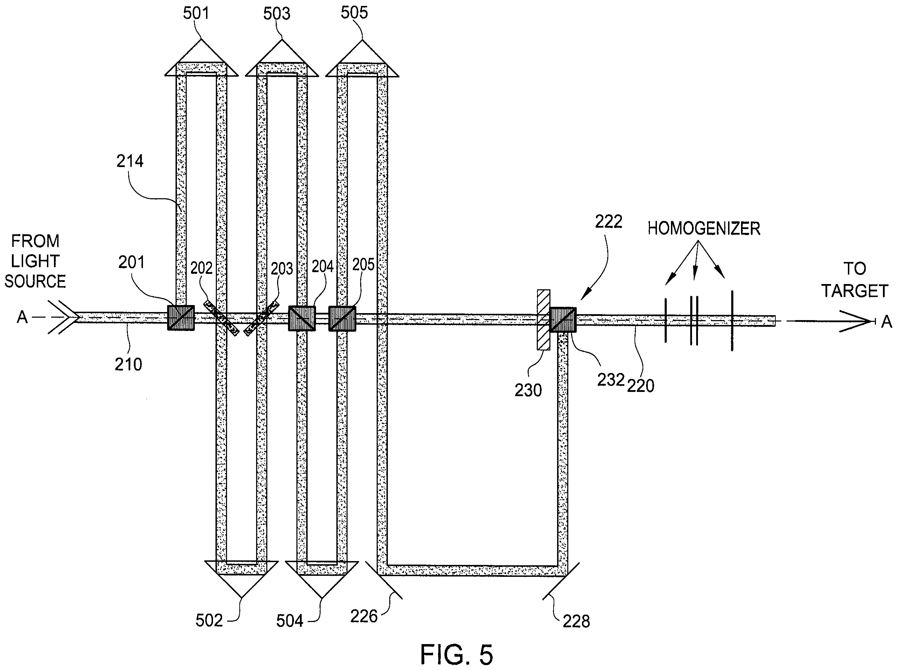

For some embodiments as depicted in FIG. 5, only single retroreflectors 501-504 may be used to redirect the off-axis component light beam(s) to subsequent beam splitters 202-205. In such embodiments, the angles of the hypotenuses of the cube beam splitter and the angles of the plate beam splitters should be alternated between adjacent beam splitters such that one beam splitter may be effectively angled 45° with respect to the optical axis A-A and an adjacent beam splitter may be effectively angled 135° with respect to the optical axis A-A as shown. In this manner, the number of optical steering devices may be reduced (e.g., from nine retroreflectors 216, 218 to five retroreflectors 501-505), thereby reducing the cost and the setup time for the decorrelator 104. The setup time may be reduced not only by having fewer components to install, but also by having fewer components to align. However, such embodiments may offer less spatial decorrelation when compared to embodiments employing two optical steering devices for every beam splitter.

Also, such embodiments with the reduced number of optical steering devices may require more lateral space to achieve the same amount of delay. For example, if $l$ is the delay length of one optical path leg in FIG. 2 between a beam splitter 201-205 and a primary retroreflector 216, then the total delay length $d$ between adjacent beam splitters may be approximated by $d = 4l$ (the upgoing leg plus the downgoing having twice the delay length plus another upgoing leg where the delay through the retroreflector is considered negligible). Depending on the desired amount of pulse stretching, the lateral spacing between a beam splitter and a primary or a secondary retroreflector 216, 218 may be about 0.2 m to 1.1 m. For some embodiments, the primary retroreflectors 216 and the secondary retroreflectors 218 may be located different distances away from the beam splitters 201-205, but that does not affect the argument since $d$ will have the same desired delay value between the different embodiments.

To achieve the same total delay length $d$ between adjacent beam splitters, embodiments that have a reduced number of optical steering devices (see FIG. 5 as opposed to the configuration shown in FIG. 2) may have the retroreflectors 501-504 located a distance $2l$ away from the beam splitters 201-205 in an effort to compensate for the reduction in path length. With only an upgoing leg and a downgoing leg each possessing a delay length of $2l$, the total delay length $d$ will equal $4l$. Therefore, the lateral spacing between a beam splitter 201-204 and the corresponding retroreflector 501-504 may be about 0.4 m to 2.2 m depending on the desired amount of pulse stretching. However, whereas the maximum delay length between the primary retroreflectors 216 and secondary retroreflectors 218 is only 2*l* in the simple example described herein, the maximum delay length between the retroreflectors 501-504 in embodiments with the reduced number of optical steering devices is always twice as much (*i.e.*, 4*l*). Therefore, embodiments of the invention with the reduced number of optical steering devices as shown in FIG. 5 may suggest twice the amount of lateral spacing in the decorrelator 104 as embodiments with two optical steering devices between each beam splitter as shown in FIG. 2.

With each off-axis component light beam experiencing a delay through an optical path to one or more optical steering devices and back to a subsequent beam splitter, the chart 250 in FIG. 2A illustrates the number of off-axis excursions experienced by each component beam output by a given beam splitter and its associated optical steering device(s) in FIG. 2. If the optical path lengths (and hence, the delays) from a given beam splitter to a subsequent beam splitter are equal for all of the beam splitters in the decorrelator 104 as shown in FIG. 2, then the number of off-axis excursions will generally represent the number of delays experienced by each component light beam.

For example, if the total delay length of an off-axis component beam is *d,* then the component light beams generated by delivering the incident light beam 210 to the first splitter 201 shown in FIG. 2 may create a transmitted on-axis component light beam 212 that has zero delay and a reflected off-axis component light beam 214 that has a 1*d* delay length as shown by the two "1"s in the first row of the chart 250. Each of these component light beams 212, 214 may be split into two additional component beams by the second beam splitter 202 such that the two on-axis component light beams transmitted through the second beam splitter 202 may have a zero delay and a 1*d* delay length and the two-off axis component light beams reaching the third beam splitter 203 may have a 1*d* delay length and a 2*d* delay length. Thus, two of the four component light beams generated by the second beam splitter 202, the primary retroreflector 216, and the secondary retroreflector 218 have a 1*d* delay length, and the other two component light beams have a zero delay and a 2*d* delay length as depicted in the second row of the chart 250.

This process may propagate down the remaining beam splitters 203-205 with each component light beam being split into two components that have zero delay added when transmitted as an on-axis component light beam and a 1*d* delay added when transmitted as an off-axis component light beam. In this example, after the last beam splitter 205 and optical steering devices, the generated component light beams may consist of a component light beam that was not delayed (*i.e.*, with zero delay), five component beams having a 1*d* delay length, ten component beams having a 2*d* delay length, ten component beams having a 3*d* delay length, five component beams having a 4*d* delay length, and one component beam having a 5*d* delay length for thirty-two total component light beams as portrayed in the last row of chart 250.

By splitting the incident coherent light beam into component light beams having various time delays, the decorrelator 104 in FIG. 2 may address the temporal coherence of the incident light beam 210. Furthermore, by introducing the time delays into the component light beams, the decorrelator 104 may function as a pulse stretcher 112 when the incident light beam 210 is a light pulse. In other words, the output pulse of the decorrelator 104 may have a lengthened pulse width due to the delays introduced by the optical path lengths to the optical steering device(s) between adjacent beam splitters and allotted to the component light beams in the decorrelator 104. The degree of pulse stretching may be adjusted by altering the off-axis optical path length between adjacent beam splitters. In this manner, the pulse width may be adjusted to match a desired pulse duration to prevent damage to the target 106, such as the substrate in a laser annealing system, and/or optimize the processing results.

In order to be effective, the separation in time due to optical travel through the off-axis optical paths including the optical steering devices (e.g., the retroreflectors 216, 218) should be on the order of a coherence length or more. As used herein, the coherence length may be generally defined as the propagation distance from a coherent light source to a point where the light wave maintains a specified degree of coherence. In optics, the coherence length L may be approximated by the formula:

$$L = \frac{\lambda^2}{n\Delta\lambda}$$

where λ is the nominal wavelength of the source, *n* is the refractive index of the medium, and Δλ is the spectral width of the source. Because the spectral width of a source is somewhat ambiguous, however, the coherence length has been defined as the optical path length difference of a self-interfering laser beam which corresponds to a 50% fringe visibility, where the fringe visibility *V* is defined as

$$V = \frac{I_{max} - I_{min}}{I_{max} + I_{min}}$$

where *I* is the fringe intensity.

Spatial decorrelation may be accomplished by an imperfect overlay of the component light beams. In other words, the beam splitters 201-205 and optical steering devices (*e.g.*, the retroreflectors 216, 218) may not be perfectly aligned in an effort to cause displacements, deviations in transmission angles of the component light beams, or both. The separation in space should be sufficient to displace the speckle pattern by at least a speckle dot width at the image plane. The speckle dot width at the image plane may be essentially the minimum resolvable spot for the laser processing system 100 and may be approximated for a laser light source as

$$D = \frac{2\lambda_0}{n\pi NA}$$

where $D$ is the diameter of the laser beam at its narrowest spot, $\lambda_0$ is the vacuum wavelength of the light, $n$ is the refractive index of the medium, and $NA$ is the numerical aperture. Thus, when air ($n$ = 1.0) is used as the transmission medium, the narrowest spot may be approximated by $D = 0.6\lambda_0/NA$.

Once the incident light beam 210 has been decorrelated in both space and time by splitting said beam into $2^N$ component light beams with N beam splitters as described herein, the component light beams from the last beam splitter 205 may be combined into an incoherent light beam 220 in a beam combiner 222 in step 310. The beam combiner 222 may be aligned with the optical axis A-A of the beam splitters 201-205 as shown in FIG. 2. In such embodiments, the on-axis component light beams from the last beam splitter 205 may be transmitted to the beam combiner 222, while the off-axis component light beams from the last beam splitter 205 may be redirected to the beam combiner 222 using any suitable optical steering device or combination of devices, such as a retroreflector, a combination of mirrors, and an optical fiber. In FIG. 2 (FIG. 5), the off-axis component beams from the last beam splitter 205 are redirected to the beam combiner 222 using a retroreflector 224 (505) and two mirrors 226, 228.

The beam combiner 222 may comprise a polarization rotator or a half-wave plate 230 and a polarizing cube beam splitter 232 aligned with the optical axis A-A of the plurality of beam splitters 201-205. For some embodiments as illustrated in FIG. 2, the half-wave plate 230 may be coupled directly to the polarizing beam splitter 232. The half-wave plate 230 may be positioned before the polarizing beam splitter 232 so that the polarization of the on-axis component light beams may be rotated 90°. Without this adjustment to the polarization, light received on one input port (face of the cube) would most likely be reflected by the polarizing beam splitter 232 and not get recombined with light received on the other input port. The polarizing beam splitter 232 may adjust the polarization of the energy in the on-axis and off-axis component light beams received from the last beam splitter 205 or from the mirrors 226, 228, respectively, so that the composite beam may be directed in a desired direction.

For some embodiments, the incident light beam 210 (and thus, the generated component light beams in the decorrelator 104) is s-polarized, or perpendicular to the plane of incidence, a plane made by the propagation direction of the light and a vector normal to a reflecting surface. S-polarization is also known as sigma-polarization or sagittal plane polarization. In such embodiments, the s-polarized on-axis component light beams may exit the half-wave plate 230 as p-polarized on-axis component light beams parallel to the plane of incidence. P-polarization is also known as pi-polarization or tangential plane polarization. In a polarizing beam splitter, s-polarized light may be completely reflected, while p-polarized light may be completely transmitted. Therefore, the p-polarized on-axis component light beams from the half-wave plate 230 may be transmitted through the polarizing beam splitter 232 and be combined with the s-polarized off-axis component light beams reflected by the hypotenuse of the polarizing cube beam splitter 232 to form the incoherent light beam 220.

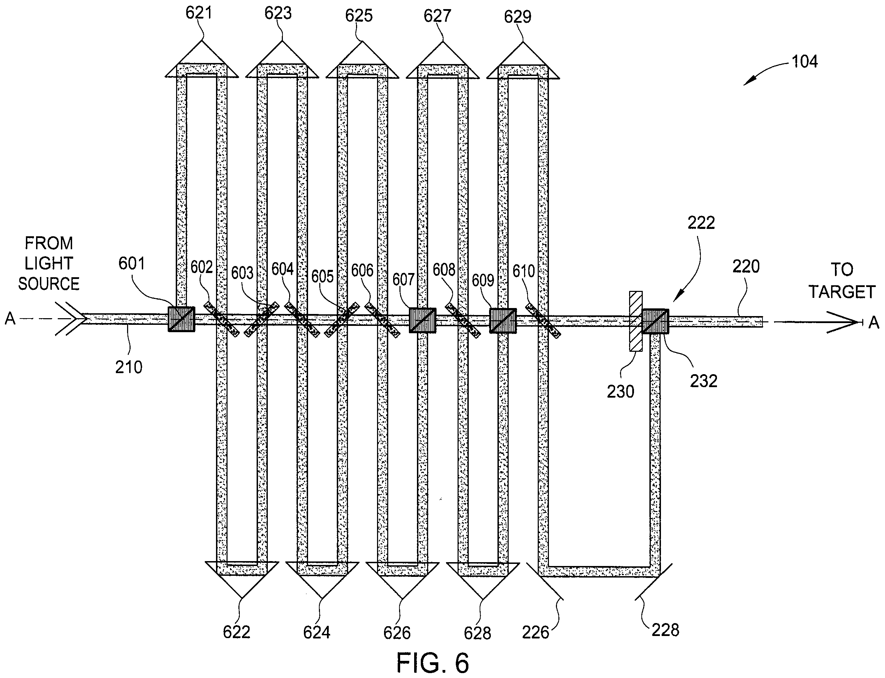

For N beam splitters, the benefit of incoherent summing may increase as the square root of the number of beams being summed ($\sqrt{2^N}$ or $2^{N/2}$). Thus, for an application, such as a pulsed laser annealing system, with a coherent light source with 40% illumination non-uniformity, for example, the non-uniformity may be improved to 7.1% (= 40%$\sqrt{2^5}$) with the decorrelator of FIGs. 2 and 5. By increasing the number of beam splitters to 10, for example, as shown in FIG. 6, the non-uniformity may be theoretically improved to 1.25% (= 40%$\sqrt{2^{10}}$). This improvement may be seen in high quality light sources, such as lasers with a small beam parameter product (BPP), the product of a laser beam's divergence angle (half-angle) and the radius of the beam at its narrowest point (beam waist). The ratio of the BPP of an actual beam to that of an ideal Gaussian beam (having the lowest possible BPP of $\lambda/\pi$) at the same wavelength is denoted as $M^2$. Thus, an $M^2$ = 2 laser may follow the theoretical non-uniformity improvement, while a lower beam quality $M^2$ = 3 laser may see a more linear non-uniformity improvement (e.g., 40%/10 = 4% for N = 10 beam splitters).

For some embodiments, as shown in FIG. 6, the decorrelator 104 may employ ten alternating beam splitters 601-610. As an example, the first, seventh, and ninth beam splitters 601, 607, 609 may be cube beam splitters, while the remaining beam splitters 602-606, 608, 610 may be plate beam splitters. The ninth beam splitter 609 may be have a splitting ratio of 30:70, while the remaining beam splitters 601-608, 610 may possess a splitting ratio of 50:50. By having alternating beam splitters 601-610, embodiments of the decorrelator 104 with ten beam splitters may redirect the off-axis component beams with nine retroreflectors 621-629 as illustrated in an effort to produce 1024 (= $2^{10}$) component light beams in the last beam splitter 610. Not only does the increased number of beam splitters theoretically improve the uniformity of the incoherent light beam 220, but the increase may also allow for greater control over the shape of the output pulse.

If the incident light beam 210 is a coherent light pulse from a laser, for example, the lateral spacing between the beam splitters 601-610 and the retroreflectors 621-629 may be decreased when compared to embodiments having fewer beam splitters, such as the embodiments of FIGs. 2 and 5, in an effort to achieve the same desired stretched pulse width of the outgoing incoherent light beam 220. For example, if the lateral spacing between the beam splitters 201-205 and the retroreflectors 501-505 is approximately 60 cm in the decorrelator 104 of FIG. 5, then the lateral spacing between the beam splitters 601-610 and the retroreflectors 621-629 may be reduced to about 30 cm in an effort to maintain the same delay and, thus, the same desired stretched pulse width at the output.

Although embodiments of the decorrelator 104 are shown in FIGs. 2, 5, and 6 with matched lateral spacing between each adjacent pair of beam splitters and the corresponding retroreflector, some embodiments may utilize different lateral spacing between each adjacent pair of beam splitters and the corresponding optical steering device. By causing the lateral spacing (and hence, the total delay length) between adjacent pairs of beam splitters and the corresponding optical steering device to be different, the temporal decorrelation may be further increased. In other words, the time delays of the component light beams from the last beam splitter may be less matched (*i.e.*, more distributed), thereby leading to more uniform illumination in the incoherent light beam 220. Moreover, some embodiments may employ a certain layout topology of optical steering devices between a pair of adjacent beam splitters (*e.g.*, a single off-axis retroreflector between adjacent beam splitters with a certain lateral spacing) and a different layout topology between another pair of adjacent beam splitters (*e.g.*, two or more optical steering devices between the pair of beam splitters most likely with a different lateral spacing) within the same decorrelator 104.

Furthermore, characteristics of the decorrelator 104-such as the number of beam splitters, the number of optical steering devices, the topology of the layout, and the dimensions of the layout (*e.g.*, the on-axis spacing between adjacent beam splitters, the lateral spacing between a beam splitter and one or more off-axis optical steering devices, and the spacing between the last beam splitter and the beam combiner)-may be selected and altered in an effort to adjust the amount of pulse stretching and to achieve a desired pulse profile when the incident light beam 210 is a coherent light pulse.

While the foregoing is directed to embodiments of the present invention, other and further embodiments of the invention may be devised without departing from the basic scope thereof, and the scope thereof is determined by the claims that follow.

## Claims

1. A method for decorrelating a coherent light beam, comprising:

providing a plurality of beam splitters (201 - 205) aligned along an optical axis (A-A);
receiving the coherent light beam with a first beam splitter (201) in the plurality;
for at least some of the beam splitters, dividing each incident light beam into an on-axis component beam traveling substantially along the optical axis and an off-axis component beam traveling substantially perpendicular to the optical axis;

**characterised by** the following steps:

combining on-axis and off-axis component beams received from a last beam splitter (205) in the plurality in a beam combiner (222) aligned with the optical axis of the beam splitters to form an incoherent light beam; and
optically steering each of the off-axis component beams to a subsequent beam splitter in the plurality of beam splitters or to the beam combiner.

2. The method of claim 1, wherein providing the plurality of beam splitters comprises providing N beam splitters aligned along the optical axis and combining the on-axis and off-axis component beams comprises combining $2^N$ on-axis and off-axis component beams from the last beam splitter.

3. The method of claim 1, wherein the coherent light beam is a coherent light pulse and the incoherent light beam is an incoherent light pulse having a pulse width longer than that of the coherent light pulse.

4. The method of claim 1, wherein optically steering the off-axis component beams to the subsequent beam splitter or to the beam combiner comprises employing a retroreflector, a mirror, an optical fiber, or a combination thereof.

5. The method of claim 1, wherein combining the on-axis and off-axis component beams comprises using a polarizing beam splitter (232) and a half-wave plate (230) as the beam combiner.

6. A method for decorrelating a coherent light beam, comprising:
providing N beam splitters (201 - 205); **characterised by** the following steps:

dividing the coherent light beam into $2^N$ component beams using the N beam splitters; and
combining the $2^N$ component beams by a beam combiner (222) aligned with the optical axis of the beam splitters to form an incoherent light beam.

7. The method of claim 6, wherein the coherent light beam is a coherent light pulse and the incoherent light beam is an incoherent light pulse having a pulse width longer than that of the coherent light pulse.

8. An apparatus for decorrelating coherent light, comprising:
a plurality of beam splitters (201 - 205) aligned along an optical axis, wherein at least some of the beam splitters are configured to divide an incident light beam into an on-axis component beam traveling substantially along the optical axis and an off-axis component beam traveling substantially perpendicular to the optical axis, a first beam splitter (201) in the plurality being configured to receive the coherent light; the apparatus **characterised in that**:

a beam combiner (222) is aligned with the optical axis of the beam splitters and configured to combine on-axis and off-axis component beams received from a last beam splitter (205) in the plurality to form incoherent light; and
a plurality of optical steering devices are configured to direct off-axis component beams to a subsequent beam splitter in the plurality of beam splitters or to the beam combiner.

9. The apparatus of claim 8, wherein the coherent light is a coherent light pulse and the incoherent light is an incoherent light pulse having a longer pulse width than the coherent light pulse.

10. The apparatus of claim 8, wherein N is the number of beam splitters in the plurality and the beam combiner is configured to receive $2^N$ on-axis and off-axis component beams from the last beam splitter.

11. The apparatus of claim 8, wherein the plurality of optical steering devices comprises at least one of a retroreflector, a combination of mirrors, and an optical fiber.

12. The apparatus of claim 8, wherein the beam splitters are non-polarizing beam splitters.

13. The apparatus of claim 8, wherein the beam splitters comprise plate beam splitters, cube beam splitters, or a combination thereof.

14. The apparatus of claim 8, wherein the beam splitters comprise 50:50 beam splitters, 30:70 beam splitters, or a combination thereof.

15. The apparatus of claim 8, wherein the beam combiner comprises a polarizing beam splitter (232) and a half-wave plate (230).

**Patentansprüche**

1. Verfahren zum Dekorrelieren eines kohärenten Lichtstrahls, umfassend:

Bereitstellen einer Vielzahl von Strahlteilern (201-205), die entlang einer optischen Achse (A-A) ausgerichtet sind;
Empfangen des kohärenten Lichtstrahls mit einem ersten Strahlteiler (201) in der Vielzahl selbiger;
für wenigstens manche der Strahlteiler, Unterteilen jedes einfallenden Lichtstrahls in einen auf der Achse liegenden Komponentenstrahl, der sich im Wesentlichen entlang der optischen Achse bewegt, und einen außerhalb der Achse liegenden Komponentenstrahl, der sich im Wesentlichen senkrecht zur optischen Achse bewegt;
**gekennzeichnet durch** die folgenden Schritte:

Kombinieren von auf der Achse und außerhalb der Achse liegenden Komponentenstrahlen, die von einem letzten Strahlteiler (205) in der Vielzahl selbiger in einem Strahlkombinierer (222) empfangen werden, der mit der optischen Achse der Strahlteiler ausgerichtet ist, um einen inkohärenten Lichtstrahl zu bilden; und
optisches Lenken jedes der außerhalb der Achse liegenden Komponentenstrahlen zu einem nachfolgenden Strahlteiler in der Vielzahl von Strahlteilern oder zum Strahlkombinierer.

2. Verfahren nach Anspruch 1, wobei das Bereitstellen der Vielzahl von Strahlteilern das Bereitstellen von N Strahlteilern umfasst, die entlang der optischen Achse ausgerichtet sind, und das Kombinieren der auf der Achse und außerhalb der Achse liegenden Komponentenstrahlen das Kombinieren von $2^N$ auf der Achse und außerhalb der Achse liegenden Komponentenstrahlen vom letzten Strahlteiler umfasst.

3. Verfahren nach Anspruch 1, wobei der kohärente Lichtstrahl ein kohärenter Lichtimpuls ist und der inkohärente Lichtstrahl ein inkohärenter Lichtimpuls ist, dessen Impulsbreite länger ist als die des kohärenten Lichtimpulses.

4. Verfahren nach Anspruch 1, wobei das optische Lenken der außerhalb der Achse liegenden Komponentenstrahlen zum nachfolgenden Strahlteiler oder zum Strahlkombinierer das Verwenden eines Retroreflektors, eines Spiegels, einer optischen Faser oder einer Kombination davon umfasst.

5. Verfahren nach Anspruch 1, wobei das Kombinieren der auf der Achse liegenden und der außerhalb der Achse liegenden Komponentenstrahlen die Verwendung eines polarisierenden Strahlteilers (232) und einer Halbwellenplatte (230) als Strahlkombinierer umfasst.

6. Verfahren zum Dekorrelieren eines kohärenten Lichtstrahls, umfassend:

Bereitstellen von N Strahlteilern (201-205); **gekennzeichnet durch** die folgenden Schritte:

Unterteilen des kohärenten Lichtstrahls in $2^N$-Komponentenstrahlen unter Verwendung von N Strahlteilern; und Kombinieren der $2^N$-Komponentenstrahlen durch einen Strahlkombinierer (222), der auf die optische Achse der Strahlteiler ausgerichtet ist, um einen inkohärenten Lichtstrahl zu bilden.

7. Verfahren nach Anspruch 6, wobei der kohärente Lichtstrahl ein kohärenter Lichtimpuls ist und der inkohärente Lichtstrahl ein inkohärenter Lichtimpuls ist, dessen Impulsbreite länger ist als die des kohärenten Lichtimpulses.

8. Vorrichtung zum Dekorrelieren von kohärentem Licht, umfassend:

eine Vielzahl von Strahlteilern (201-205), die entlang einer optischen Achse ausgerichtet sind, wobei wenigstens manche der Strahlteiler konfiguriert sind, um einen einfallenden Lichtstrahl in einen auf der Achse liegenden Komponentenstrahl, der sich im Wesentlichen entlang der optischen Achse bewegt, und einen außerhalb der Achse liegenden Komponentenstrahl, der sich im Wesentlichen senkrecht zur optischen Achse bewegt, zu teilen, wobei ein erster Strahlteiler (201) in der Vielzahl selbiger so konfiguriert ist, dass er das kohärente Licht empfängt; wobei die Vorrichtung **dadurch gekennzeichnet ist, dass** ein Strahlkombinierer (222) auf die optische Achse der Strahlteiler ausgerichtet und zum Kombinieren von auf der Achse und außerhalb der Achse liegenden Komponentenstrahlen, die von einem letzten Strahlteiler (205) in der Vielzahl selbiger empfangen werden, konfiguriert ist, um inkohärentes Licht zu bilden; und eine Vielzahl von optischen Lenkvorrichtungen konfiguriert ist, um außerhalb der Achse liegende Komponentenstrahlen auf einen nachfolgenden Strahlteiler in der Vielzahl von Strahlteilern oder auf den Strahlkombinierer zu lenken.

9. Vorrichtung nach Anspruch 8, wobei das kohärente Licht ein kohärenter Lichtimpuls ist und das inkohärente Licht ein inkohärenter Lichtimpuls ist, der eine längere Impulsbreite als der kohärente Lichtimpuls aufweist.

10. Vorrichtung nach Anspruch 8, wobei N die Anzahl der Strahlteiler in der Vielzahl selbiger ist und der Strahlkombinierer so konfiguriert ist, dass er $2^N$ auf der Achse und außerhalb der Achse liegende Komponentenstrahlen vom letzten Strahlteiler empfängt.

11. Vorrichtung nach Anspruch 8, wobei die Vielzahl der optischen Lenkvorrichtungen einen Retroreflektor, eine Kombination von Spiegeln und/oder eine optische Faser umfasst.

12. Vorrichtung nach Anspruch 8, wobei die Strahlteiler nicht polarisierende Strahlteiler sind.

13. Vorrichtung nach Anspruch 8, wobei die Strahlteiler Plattenstrahlteiler, Würfelstrahlteiler oder eine Kombination davon umfassen.

14. Vorrichtung nach Anspruch 8, wobei die Strahlteiler 50:50-Strahlteiler, 30:70-Strahlteiler oder eine Kombination davon umfassen.

15. Vorrichtung nach Anspruch 8, wobei der Strahlkombinierer einen polarisierenden Strahlteiler (232) und eine Halbwellenplatte (230) umfasst.

**Revendications**

1. Procédé de décorrélation d'un faisceau de lumière cohérente, comprenant :

de fournir une pluralité de séparateurs de faisceau (201 - 205) alignés le long d'un axe optique (A-A) ; de recevoir le faisceau de lumière cohérente avec un premier séparateur de faisceau (201) aligné dans la pluralité ; pour au moins une partie des séparateurs de faisceau, de diviser chaque faisceau de lumière incidente en un faisceau de composant sur axe voyageant essentiellement le long de l'axe optique et un faisceau de composant hors axe voyageant essentiellement perpendiculairement à l'axe optique ; **caractérisé par** les étapes suivantes :

mélanger les faisceaux de composant sur axe et hors axe reçus venant d'un dernier séparateur de faisceau (205) dans la pluralité dans un mélangeur de faisceaux (222) aligné avec l'axe optique des séparateurs de faisceau pour former un faisceau de lumière incohérente ; et

guider optiquement chacun des faisceaux de composant hors axe vers un séparateur de faisceau suivant dans la pluralité de séparateurs de faisceau ou vers le mélangeur de faisceaux.

2. Procédé selon la revendication 1, dans lequel fournir la pluralité de séparateurs de faisceau comprend de fournir N séparateurs de faisceau alignés le long de l'axe optique, et mélanger les faisceaux de composant sur axe et hors axe comprend de mélanger $2^N$ faisceaux de composant sur axe et hors axe venant du dernier séparateur de faisceau.

3. Procédé selon la revendication 1, dans lequel le faisceau de lumière cohérente est une impulsion de lumière cohérente et le faisceau de lumière incohérente est une impulsion de lumière incohérente ayant une largeur d'impulsion plus longue que celle de l'impulsion de lumière cohérente.

4. Procédé selon la revendication 1, dans lequel le guidage optique des faisceaux de composant hors axe vers le séparateur de faisceau suivant ou le mélangeur de faisceaux comprend d'employer un rétroréflecteur, un miroir, une fibre optique ou une combinaison de ceux-ci.

5. Procédé selon la revendication 1, dans lequel mélanger les faisceaux de composant sur axe et hors axe comprend d'utiliser un séparateur de faisceau polarisant (232) et une lame demi-onde (230) en tant que le mélangeur de faisceaux.

6. Procédé de décorrélation d'un faisceau de lumière cohérente, comprenant :

de fournir N séparateurs de faisceau (201 - 205), **caractérisé par** les étapes suivantes :

diviser le faisceau de lumière cohérente en $2^N$ faisceaux de composant en utilisant les N faisceaux de composant ; et
mélanger les $2^N$ faisceaux de composant par un mélangeur de faisceaux (222) aligné avec l'axe optique des séparateurs de faisceau pour former un faisceau de lumière incohérente.

7. Procédé selon la revendication 6, dans lequel le faisceau de lumière cohérente est une impulsion de lumière cohérente et le faisceau de lumière incohérente est une impulsion de lumière incohérente ayant une largeur d'impulsion plus longue que celle de l'impulsion de lumière cohérente.

8. Appareil pour décorréler de la lumière cohérente, comprenant :

une pluralité de séparateurs de faisceau (201 - 205) alignés le long d'un axe optique, dans lequel au moins une partie des séparateurs de faisceau est configurée pour diviser un faisceau de lumière incidente en un faisceau de composant sur axe voyageant essentiellement le long de l'axe optique et un faisceau de composant hors axe voyageant essentiellement perpendiculairement à l'axe optique,
un premier séparateur de faisceau (201) dans la pluralité étant configuré pour recevoir la lumière cohérente ; l'appareil **caractérisé en ce que** :

un mélangeur de faisceaux (222) est aligné avec l'axe optique des séparateurs de faisceaux et configuré pour mélanger les faisceaux de composant sur axe et hors axe reçus venant d'un dernier séparateur de faisceau (205) dans la pluralité pour former de la lumière incohérente ; et
une pluralité de dispositifs de guidage optique est configurée pour diriger les faisceaux de composant hors axe vers un séparateur de faisceau suivant dans la pluralité de séparateurs de faisceau ou vers le mélangeur de faisceaux.

9. Appareil selon la revendication 8, dans lequel la lumière cohérente est une impulsion de lumière cohérente et la lumière incohérente est une impulsion de lumière incohérente ayant une largeur d'impulsion plus longue que l'impulsion de lumière cohérente.

10. Appareil selon la revendication 8, dans lequel N est le nombre de séparateurs de faisceaux dans la pluralité et le mélangeur de faisceaux est configuré pour recevoir $2^N$ faisceaux de composant sur axe et hors axe venant du dernier séparateur de faisceau.

11. Appareil selon la revendication 8, dans lequel la pluralité de dispositifs de guidage optique comprend au moins un rétroréflecteur, une combinaison de miroirs et une fibre optique.

12. Appareil selon la revendication 8, dans lequel les séparateurs de faisceau sont des séparateurs de faisceau non-polarisants.

13. Appareil selon la revendication 8, dans lequel les séparateurs de faisceau comprennent des séparateurs de faisceau en plaque, des séparateurs de faisceau cubiques ou une combinaison de ceux-ci.

14. Appareil selon la revendication 8, dans lequel les séparateurs de faisceau comprennent des séparateurs de faisceau 50:50, des séparateurs de faisceau 30:70 ou une combinaison de ceux-ci.

15. Appareil selon la revendication 8, dans lequel le mélangeur de faisceaux comprend un séparateur de faisceau polarisant (232) et une lame demi-onde (230).

EP 2 185 308 B1

100

102 LIGHT SOURCE

104 DECORRELATOR

106 TARGET

108

110

FIG. 1A

111

112 PULSE STRETCHER

8 ns

20-80 ns

FIG. 1B

FIG. 2

250

| BEAM SPLITTERS | DELAYS | | | | | | TOTAL PATHS |
|---|---|---|---|---|---|---|---|
| | 0 | 1 | 2 | 3 | 4 | 5 | |
| 201 | 1 | 1 | 0 | 0 | 0 | 0 | 2 |
| 202 | 1 | 2 | 1 | 0 | 0 | 0 | 4 |
| 203 | 1 | 3 | 3 | 1 | 0 | 0 | 8 |
| 204 | 1 | 4 | 6 | 4 | 1 | 0 | 16 |
| 205 | 1 | 5 | 10 | 10 | 5 | 1 | 32 |

## FIG. 2A

300

| | |
|---|---|
| PROVIDE A PLURALITY OF BEAM SPLITTERS ALIGNED ALONG AN OPTICAL AXIS | 302 |
| RECEIVE A COHERENT LIGHT BEAM WITH A FIRST BEAM SPLITTER IN THE PLURALITY | 304 |
| FOR EACH BEAM SPLITTER, DIVIDE EACH INCIDENT LIGHT BEAM INTO AN ON-AXIS COMPONENT BEAM AND AN OFF-AXIS COMPONENT BEAM | 306 |
| OPTICALLY STEER THE OFF-AXIS COMPONENT BEAMS TO A SUBSEQUENT BEAM SPLITTER IN THE PLURALITY OF BEAM SPLITTERS | 308 |
| COMBINE THE ON-AXIS AND OFF-AXIS COMPONENT BEAMS RECEIVED FROM A LAST BEAM SPLITTER IN THE PLURALITY TO FORM AN INCOHERENT LIGHT BEAM | 310 |

## FIG. 3

FIG. 4

FIG. 5

EP 2 185 308 B1

FIG. 6

FROM LIGHT SOURCE

TO TARGET

621 623 625 627 629

601 602 603 604 605 606 607 608 609 610

210

222

220

230 232

622 624 626 628 226 228

104

EP 2 185 308 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2004120050 A1
- US 5148318 A